# EUROPEAN PATENT APPLICATION

(11) **EP 4 114 155 A1**
(43) Date of publication of application: **04.01.2023**
(21) Application number: 21182028.7
(22) Date of filing: 28.06.2021
(51) Int. Cl.: H05K 7/14, H05K 9/00, H02M 1/44, H02M 7/00

(54) **BUSBAR ASSEMBLY COMPRISING A MAGNETIC CORE DEVICE**

(71) Applicant: Valeo eAutomotive France SAS, 95800 Cergy (FR)
(72) Inventor: POUILLY, Aurélien, 95800 Cergy (FR); LOPES, Christophe, 95800 Cergy (FR)
(74) Representative: Valeo Powertrain Systems

(57) **Abstract**

The invention concerns a busbar assembly (1) of an electrical equipment, the busbar assembly (1) comprising a set of electrical plate conductors (2), at least one magnetic core device (3), connecting elements (4) configured to electrically connect each of the set of electrical plate conductors (2) to an electronic board of the electrical equipment, a mechanical holder (5) having a first lateral face (521) comprising slots, each slot being respectively traversed by one electrical plate conductor of the set of electrical plate conductors (2), the set of electrical plate conductors (2) being configured to pass through the at least one magnetic core device (3), the mechanical holder (5) being configured to mechanically support the set of electrical plate conductors (2), the mechanical holder (5) being independent from the at least one magnetic core device (3).

## Description

### FIELD OF THE INVENTION

The present invention concerns a mechatronic integration of an assembly comprising electrical plate conductors, forming a busbar adapted to deliver electrical power, and at least one magnetic core device for electromagnetic filtering purposes.

### BACKGROUND OF THE INVENTION

As is known, an electric or a hybrid automotive vehicle presents an electric drive comprising an electric motor and other electrical equipment, such as power converters, which need to be supplied either by a high voltage power supply, or in contrary, by a low voltage power supply. In this context, power converters are configured to convert an input voltage into an output voltage. For example, an inverter converts a direct current (DC) voltage from a high-voltage power supply battery to an alternating current (AC) electrical power to feed the electric motor to drive the vehicle. As another example, an on-board charger (OBC) converts an AC voltage from an external electrical network into a DC voltage to charge the high-voltage power supply battery.

In a general manner, such power converters present a plurality of electrical components, such as electrical plate conductors forming a busbar, causing electromagnetic interference (EMI) that may disturb the proper operation of the power converter, especially in a high-power environment. Thus, electromagnetic (EM) requirements are enforced in order to ensure that the power converter is able to operate in its EM environment and to protect other nearby electrical equipment from eventual EM emissions originating from the power converter.

In particular, some electrical components (magnetic cores, capacitive elements arranged in a capacitive module, resistive elements, a DC link capacitor), adapted to filter EM emissions, are connected to the busbar. The electrical components may especially undergo vibrations partly due to EM interferences. Therefore, a mechatronic integration of the electrical components should allow to mechanically withstand the vibrations while respecting the EM requirements.

In this context, the main objective of the present invention is to provide a busbar assembly integrating at least one magnetic core device for electromagnetic filtering, the busbar assembly presenting an improved mechatronic integration. The present invention also provides a corresponding assembling process which simplifies the manufacturing process.

### SUMMARY OF THE INVENTION

According to a first aspect of the invention, the present invention concerns a busbar assembly of an electrical equipment, the busbar assembly comprising a set of electrical plate conductors, at least one magnetic core device, connecting elements, and a mechanical holder. The set of electrical plate conductors is configured to pass through the at least one magnetic core device. The connecting elements are configured to electrically connect each of the set of electrical plate conductors to an electronic board of the electrical equipment. The mechanical holder has a first lateral face comprising slots, each slot being respectively traversed by one electrical plate conductor of the set of electrical plate conductors, the mechanical holder being configured to mechanically support the set of electrical plate conductors, the mechanical holder being independent from the at least one magnetic core device.

Therefore, the mechanical holder mechanically supports the set of electrical plate conductors and is independent both from the at least one magnetic core device and from the electronic board from a mechanical support point of view. Each of the mechanical holder, the at least one magnetic core device, and the electronic board can thus be mounted using similar mechanical fixations, such as screws, thus using the same screw drivers or riveting tools, without having to use glue. Consequently, the present invention presents the substantial gain of easing the mechatronic integration of the electrical equipment and on a secondary basis of reducing the vibrations of the electrical equipment and easing the vibration tests.

Another advantage of the present invention may be that the busbar assembly may form a standard and scalable pre-assembly which eases the manufacturing process of the electrical equipment, reduces the associated manufacturing costs, and improves the compacity of the electrical equipment.

According to an embodiment, the connecting elements comprise vertical pins, each of the set of electrical plate conductors having a receiving end protruding from the corresponding electrical plate conductor, the receiving ends being shifted one from another in a longitudinal direction of the set of electrical plate conductors such that each receiving end is configured to receive a corresponding vertical pin.

According to an embodiment, each of the set of electrical plate conductors has two faces being opposite one to another. Then, the mechanical holder comprises buffer elements abutting the two faces of each of the set of electrical plate conductors, the buffer elements being configured to allow a positioning of the set of electrical plate conductors in a substantially perpendicular direction with respect to the two faces of each of the set of electrical plate conductors.

According to an embodiment, the mechanical holder comprises openings on a second lateral face opposite to the first lateral face, the openings facing each of the receiving ends of the set of electrical plate conductors such that each receiving end goes through and beyond the corresponding opening, the vertical pins being located on an opposite side of the mechanical holder than the set of electrical plate conductors.

According to an embodiment, the mechanical holder comprises guiding elements for positioning the vertical pins.

According to an embodiment, the mechanical holder comprises a fixation system configured to attach the mechanical holder to a housing of the electrical equipment.

The mechanical holder may comprise a positioning device configured to position the mechanical holder with respect to the housing, thus helping to improve aligning the mechanical holder with respect to the housing.

According to an embodiment, each of the set of electrical plate conductors comprises a stop system configured to abut a face of one of the at least one magnetic core device. Such stop systems allow advantageously to ensure a horizontal positioning of the at least one magnetic core device along the set of electrical plate conductors.

According to an embodiment, the at least one magnetic core device comprises a fixation system configured to attach the at least one magnetic core device to a housing of the electrical equipment. Such a configuration of the fixation system, for instance using screws, permit that the weight of the at least one magnetic core device is supported by the housing rather than by the set of electrical plate conductors, or by the mechanical holder for instance.

According to an embodiment, the at least one magnetic core device comprises two magnetic core devices being respectively located on both sides of the mechanical holder.

According to an embodiment, the mechanical holder comprises a fixing claw configured to attach together the mechanical holder and one of the two magnetic core devices.

The present invention also concerns an electrical equipment comprising the busbar assembly, an electronic board, and a housing, the housing being configured to accommodate the busbar assembly and the electronic board. The electronic board comprises spring connectors configured to receive the connecting elements of the busbar assembly.

According to an embodiment, the electrical equipment comprises other electronic components such as a DC-link capacitor and a power section, the electrical equipment being an inverter configured to convert a direct current (DC) voltage coming from a high-voltage power supply battery into an alternating current (AC) voltage so as to drive an electric motor of an electric drive of an electric vehicle or of a hybrid electric vehicle. The AC voltage may be a multiphase AC voltage, in particular a three-phase voltage. Alternatively, the electrical equipment may be an on-board charger or a DC/DC converter of the electric vehicle or the hybrid electric vehicle

Another aspect of the invention is an electric drive, comprising an electric motor and the inverter as described above configured to convert a DC voltage into an AC voltage to drive the electric motor.

A further aspect of the invention is a vehicle, comprising the electric drive for driving the vehicle. The vehicle may comprise a battery, preferably a rechargeable battery for providing the DC voltage to the inverter, if applicable.

According to an embodiment of a second aspect of the invention, the invention relates to an assembling process of the busbar assembly as described previously, the process comprising:
- sliding one of the at least one magnetic core device along the set of electrical plate conductors;
- mounting the mechanical holder laterally on the set of electrical plate conductors;
- if appropriate, sliding another one of the at least one magnetic core device along the set of electrical plate conductors;
- inserting and attaching the vertical pins on the receiving ends of the set of electrical plate conductors.

According to an embodiment of the second aspect of the invention, an assembling process of the electrical equipment described above comprises:
- assembling the busbar assembly as described previously;
- disposing the electronic board into the housing and attaching the electronic board to the housing;
- inserting the busbar assembly into the housing above the electronic board, such that the connecting elements of the busbar assembly are inserted into the spring connectors of the electronic board;
- mechanically attaching the mechanical holder and the at least one magnetic core device to the housing.

Although embodiments have been described with reference to a number of illustrative embodiments thereof, it should be understood that other modifications and embodiments can be derived by those skilled in the art that will fall within the scope of the principles of this disclosure.

These and other objects, features, aspects and advantages of the present invention will become apparent to those skilled in the art from the following detailed description, which, taken in conjunction with the annexed drawings, discloses preferred embodiments of the present invention.

### BRIEF DESCRIPTION OF THE DRAWINGS

The invention will be better understood on reading the description that follows, and by referring to the appended drawings given as non-limiting examples, in which identical references are given to similar objects and in which:
Figure 1 illustrates a view of an example of electrical equipment comprising an example of busbar assembly according to a first aspect of the invention;
Figure 2 and 3 illustrate two views of an example of the busbar assembly according to the first aspect of the invention;
Figure 4 illustrates an exploded view of an example of the busbar assembly according to the first aspect of the invention;
Figure 5 illustrates a view of an example of the busbar assembly according to the first aspect of the invention and an electronic board;
Figure 6 and 7 illustrate two views of an example of mechanical holder according to the first aspect of the invention.

### DETAILED DESCRIPTION

Selected embodiments of the present invention will now be explained with reference to the drawings. It will be apparent to those skilled in the art from this disclosure that the following descriptions of the embodiments of the present invention are provided for illustration only and not for the purpose of limiting the invention as defined by the appended claims and their equivalents.

The invention relates to an electric vehicle or a hybrid electric automotive vehicle comprising wheels and an electric drive configured to drive at least indirectly at least one of the wheels of the vehicle. The electric drive comprises an electric motor and electrical equipment such as power converters, for instance an inverter being configured to drive the electric motor by means of an AC voltage generated by the inverter.

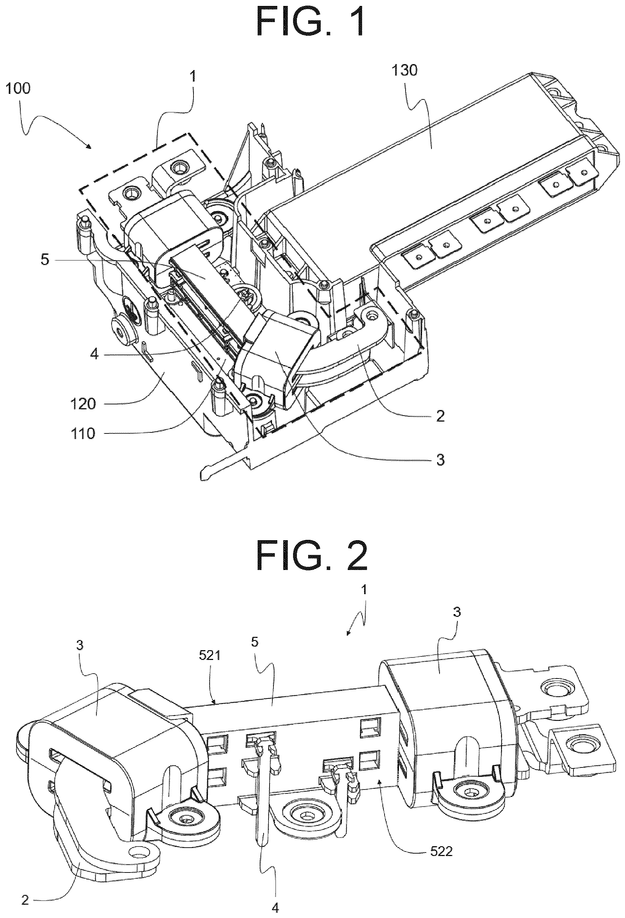

Figure 1 illustrates an example of electrical equipment 100 according to an embodiment of a first aspect of the present invention. According to the present embodiment, the electrical equipment 100 is an inverter configured to convert a DC voltage coming from a high-voltage power supply battery into an AC voltage in order to drive the electric motor. The AC voltage may be a multiphase AC voltage, in particular a three-phase voltage. Alternatively, the electrical equipment 100 may be, for example, an on-board charger or a DC/DC converter of the electric or hybrid automotive vehicle.

The electrical equipment 100 comprises notably a busbar assembly 1, a housing 120, an electronic board 110 mounted on a bottom plate of the housing 120, and other electronic components 130 configured to be electrically connected to the busbar assembly 1. The housing 120 is configured to accommodate the busbar assembly 1, the electronic board 110, and the other electronic components 130.

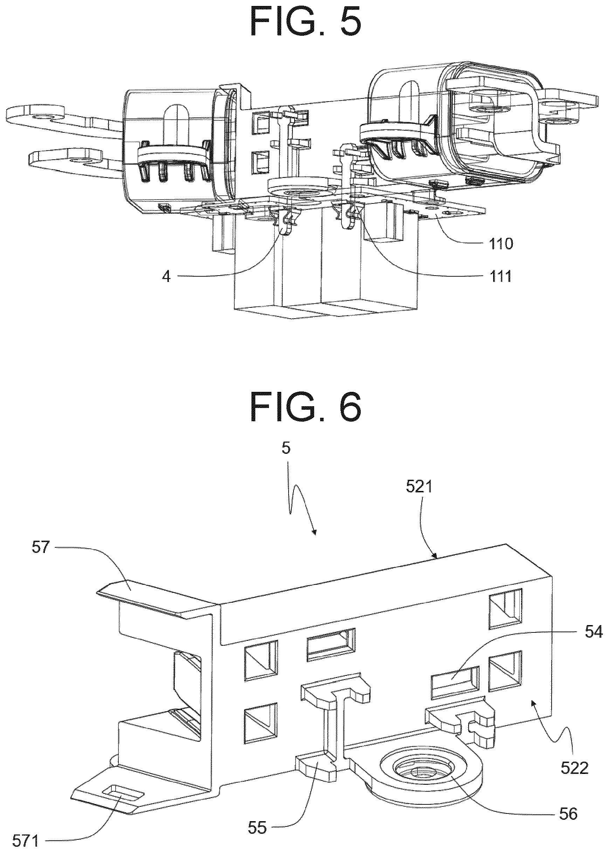

The electronic board is preferably a printed circuit board (PCB) on which the busbar assembly is mounted. Capacitive and resistive elements can be mounted on the electronic board, which filteri potential electromagnetic emissions. The capacitive elements may for instance comprise X capacitors and/or Y capacitors. In particular, with reference to Figure 5, the electronic board 110 comprises, in a preferred manner, spring connectors 111 configured to receive connecting elements 4 of the busbar assembly. In the electrical equipment according to the present embodiment of the invention, the electronic board may advantageously be located closer to the ground, thus reducing an inductance of a grounding path.

In the embodiment shown, the electronic components are placed in a vertical bottom direction with respect to the housing walls. This permits, for instance, to add a thermal interface to cool them, or to add additional mechanical fixation, for instance, a glue, improving vibration behavior.

According to the present embodiment, the housing 120 comprises a top cover, the bottom plate, sidewalls, and a main chamber defined by the bottom plate and the sidewalls. The main chamber is used for accommodating the electronic board and the busbar assembly 1. Other elements of the electrical equipment 100, such as an insulating board and a heat sink, may also be accommodated in the main chamber.

Additionally, the other electronic components 130 may comprise a DC-link capacitor and a power section. The power section comprises, in particular, switching elements, arranged in power modules.

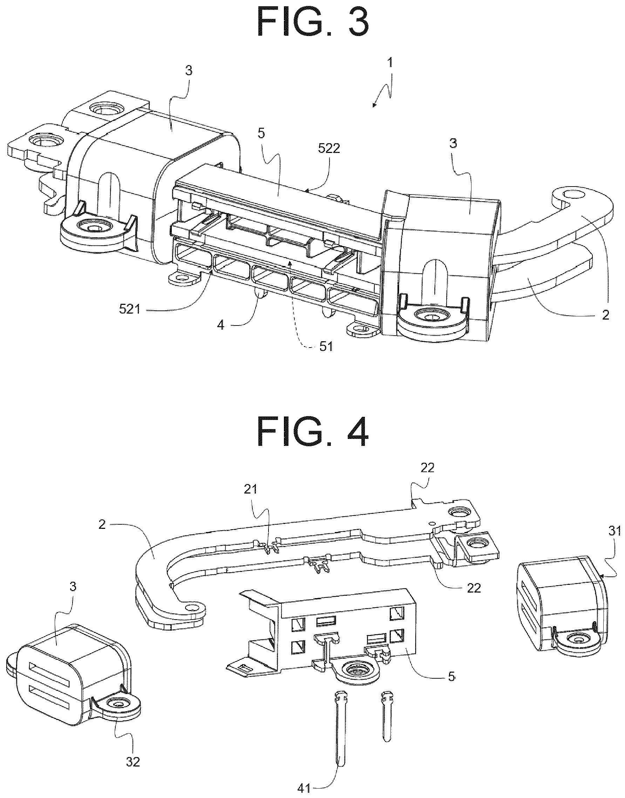

Figures 2 and 3 illustrate, according to different perspectives, an example of the busbar assembly 1 of the electrical equipment according to an embodiment of the first aspect of the invention. Figure 4 illustrates an exploded view of the busbar assembly according to the present embodiment. In the particular case of the inverter, the busbar assembly ensures the electrical connection between the high-voltage power supply battery and the electric motor ensuring the propulsion of the vehicle.

The busbar assembly 1, according to the present embodiment, comprises a set of electrical plate conductors 2, at least one magnetic core device 3, connecting elements 4 configured to electrically connect each of the set of electrical plate conductors 2 to the electronic board of the electrical equipment, and a mechanical holder 5.

The set of electrical plate conductors 2 is configured to pass through the at least one magnetic core device 3. In other words, the at least one magnetic core device 3 surrounds at least partially the set of electrical plate conductors 2.

As illustrated in Figure 3, the mechanical holder 5 has a first lateral face 521 comprising slots 51, each slot 51 being respectively traversed by one electrical plate conductor of the set of electrical plate conductors 2, the mechanical holder 5 being configured to mechanically support the set of electrical plate conductors 2. Moreover, the mechanical holder 5 is independent from the at least one magnetic core device 3. Hence, the mechanical fixation of respectively the mechanical holder and of the at least one magnetic core device can advantageously be performed in a separate manner.

In brief, the mechanical holder mechanically supports the set of electrical plate conductors and is independent both from the at least one magnetic core device and from the electronic board from a mechanical support point of view. Each of the mechanical holder, the at least one magnetic core device, and the electronic board may be mounted using similar mechanical fixations, such as screws, thus using same screw drivers or riveting tools, without having to use glue. Consequently, the busbar assembly presents the substantial gain of easing the mechatronic integration of the electrical equipment, and, on a secondary basis, reducing the vibrations of the electrical equipment and easing the vibration tests.

Another advantage of the present embodiment, is that the busbar assembly forms a standard and scalable pre-assembly which eases the manufacturing process of the electrical equipment, reducing the associated manufacturing costs, and improves the compacity of the electrical equipment.

Moreover, the busbar assembly, according to the present embodiment, is an alternative solution to the use of a conventional overmolded busbar, in which the electrical plate conductors are overmolded by a plastic material. In presence of thermal solicitations, the conventional overmolded busbar may undergo cracks that may eventually lead to the failure of the conventional overmolded busbar. In the inventive busbar assembly, the mechanical holder is advantageously not overmolded and thus presents an improved thermomechanical behavior compared to the conventional overmolded busbar while still ensuring the electrical insulation and the mechanical handling of the set of electrical plate conductors.

With reference to Figure 4, the connecting elements 41 may comprise vertical pins 41. Then, each of the set of electrical plate conductors 2 has, advantageously, a receiving end 21 protruding from the corresponding electrical plate conductor. The receiving ends 21 present preferably of fork shape. Moreover, the receiving ends 21 are preferably shifted one from another in a longitudinal direction of the set of electrical plate conductors 2 such that each receiving end 21 is configured to receive a corresponding vertical pin 41. Thus, the vertical pins are longitudinally distant from one another. Such a configuration of the connecting elements allows, advantageously, to deport the busbar assembly from the electronic board and thus to be able to ensure the mechanical support of the set of electrical plate conductors of the busbar assembly independently from the electronic board.

The fixation of the vertical pins 41 to each respective receiving end 21 may advantageously be achieved by for instance a crimping process, or an electro-soldering process.

In a general manner, each of the set of electrical plate conductors present a strip shape. Furthermore, the electrical plate conductors are generally made out of a metallic material, most commonly copper.

In the context of the electrical equipment being an inverter, the set of electrical plate conductors are comprised of a DC busbar which notably presents a positive DC electrical plate conductor and a negative DC electrical plate conductor. The positive and the negative DC electrical plate conductors are, in particular, arranged one above the other in a substantially vertical direction.

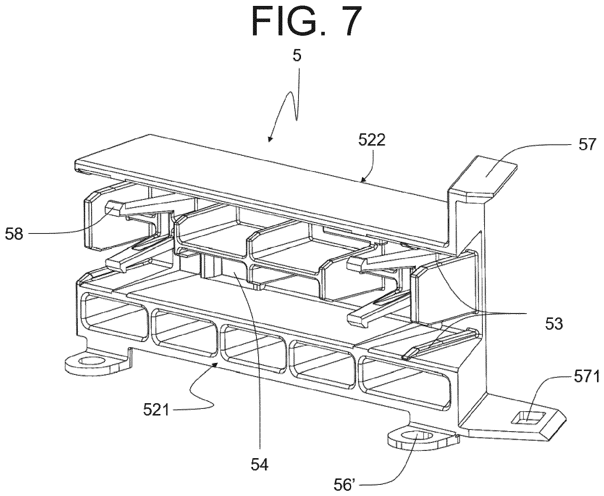

The mechanical holder 5, as illustrated in Figures 6 and 7, will now be detailed. The mechanical holder is advantageously made out of a plastic material, preferably a PBT GF30 or PPS GF30.

Each of the set of electrical plate conductors 2 has notably two faces being opposite one to another. Then, as represented in Figure 7, the mechanical holder 5 comprises advantageously buffer elements 53 abutting the two faces of each of the set of electrical plate conductors 2. The buffer elements 53 are notably configured to allow a positioning of the set of electrical plate conductors 2 in a substantially perpendicular direction with respect to the two faces of each of the set of electrical plate conductors 2.

Moreover, the buffer elements may be adapted to be able to deform and thus to attenuate potential mechanical vibrations of the busbar assembly, especially the mechanical vibrations caused by the set of electrical plate conductors. This can be achieved by selecting an appropriate material for the buffer elements.

In addition, as depicted in Figure 7, the mechanical holder 5 may comprise a number of clips 58 blocking the set of electrical plate conductors in a substantially transverse direction with respect to the longitudinal direction of the set of electrical plate conductors. For instance, the number of clips 58 may comprise two clips per electrical plate conductor, the two clips being at a distance from one another in the longitudinal direction. The clips 58 would allow to control the transversal positioning of the set of electrical plate conductors.

Furthermore, in reference to Figures 6 and 7, the mechanical holder 5 may comprise openings 54 on a second lateral face 522 opposite to the first lateral face 521 of the mechanical holder 5, the openings 54 facing each of the receiving ends of the set of electrical plate conductors such that each receiving end goes through and beyond the corresponding opening. Then, the vertical pins are notably located on an opposite side of the mechanical holder 5 than the set of electrical plate conductors 2.

Moreover, the mechanical holder 5 may advantageously comprise guiding elements 55, represented in Figure 6, for positioning the vertical pins.

With reference to Figure 6, the mechanical holder 5 may further comprise a fixation system 56 configured to attach the mechanical holder 5 to the housing of the electrical equipment, for instance by the mean of screws. Hence, the mechanical holder 5, is directly fixated to the housing, the housing thus ensuring the mechanical holding of the set of electrical plate conductors, and reducing mechanical vibrations of the set of electrical plate conductors, compared to a solution where the set of the electrical plate conductors are not supported by the housing.

The mechanical holder 5 may comprise a positioning device 56', adapted to positioning the mechanical holder 5 with respect to the housing 120. The positioning device 56' allows to position the mechanical holder 5 with respect to the housing 120 or to the electronic board. For the embodiment shown in particular in fig. 7, the positioning device 56' may be hole which may engage with a pin of the housing 120. The pin is not explicitly shown in the figures. In particular, the holes 56' as the positioning device 56' allow locating the housing 120 with respect to both, the electronic board and the mechanical holder.

As illustrated in Figure 4 showing an exploded view of an example of the busbar assembly according to the present embodiment of the invention, each of the set of electrical plate conductors 2 advantageously comprise a stop system 22 configured to abut a face 31 of one of the at least one magnetic core device 3. Such stop systems allow advantageously to ensure a horizontal positioning of the at least one magnetic core device 3 along the set of electrical plate conductors 2.

The at least one magnetic core device is notably configured to act as an inductance to filter either common mode or differential mode currents or a combination of both. The at least one magnetic core device may, preferably, comprise, two E-shaped portions or two U-shaped portions.

Moreover, as represented in Figure 4, the at least one magnetic core device 3 may comprise a fixation system 32 configured to attach the at least one magnetic core device 3 to the housing of the electrical equipment. Such a configuration of the fixation system, for instance using screws, permit that the weight of the at least one magnetic core device is supported by the housing rather than by the set of electrical plate conductors, or by the mechanical holder for instance.

Advantageously, for the example of busbar assembly according to the first aspect of the invention, represented in Figures 1 to 4, the at least one magnetic core device 3 comprises two magnetic core devices being respectively located on both sides of the mechanical holder 5. Two magnetic core devices allow advantageously to enhance the EM filtering capabilities of the busbar assembly. Although a configuration in which the at least one magnetic core device comprises only a single magnetic core device could be sufficient.

Furthermore, as depicted in Figures 6 and 7, in the embodiment in which the at least one magnetic core device comprises two magnetic core devices, the mechanical holder 5 may advantageously comprise a fixing claw 57 configured to attach together the mechanical holder 5 and one of the two magnetic core devices. Hence, such a fixing claw allow to position in a substantially longitudinal direction the corresponding magnetic core device with respect to the mechanical holder and thus to the set of electrical plate conductors.

The fixing claw 57 can further comprise a locking system 571, the corresponding magnetic core device having another locking system matching the locking system 571 of the fixing claw 57 such that both locking systems are configured to attach together the mechanical holder 5 and the corresponding magnetic core device by for instance clipping or snapping.

Therefore, the mechanical holder allows to ensure the relative positioning of the set of electrical plate conductors and of the at least one magnetic core device with respect to one another. In particular, the mechanical holder allows fixation of the magnetic core devices 3 and the electronic board to the electrical plate conductors while being mounted to the housing120.

With reference to Figure 4, an assembling process of the busbar assembly, according to an embodiment of a second aspect of the invention, comprises:
- sliding one of the at least one magnetic core device 3 along the set of electrical plate conductors 2 in particular until it reaches the stop system 22;
- mounting the mechanical holder 5 laterally on the set of electrical plate conductors 2;
- if appropriate, sliding another one of the at least one magnetic core device 3 along the set of electrical plate conductors 2;
- inserting and attaching the vertical pins 41 on the receiving ends 21 of the set of electrical plate conductors 2.

The attaching the vertical pins 41 on the receiving ends 21 may, in a preferred manner, comprise a crimping process, or an electro-soldering process.

The other one of the at least one magnetic core device 3 may advantageously be attached to the mechanical holder through a snapping process by the means of the previously described fixing claw.

Hence, the proposed assembling process of the busbar assembly is simple, easing thus the manufacturing process of the electrical equipment.

With reference to Figure 1, an assembling process of the electrical equipment 100, according to another embodiment of the second aspect of the invention, comprises:
- assembling the busbar assembly 1 as previously described;
- disposing the electronic board 110 into the housing 120 and attaching the electronic board 110 to the housing 120;
- inserting the busbar assembly 1 into the housing 120 above the electronic board 110, such that the connecting elements 4 of the busbar assembly 1 are inserted into the spring connectors 111 of the electronic board 110 as illustrated in Figure 5;
- mechanically attaching the mechanical holder 5 and the at least one magnetic core device 3 to the housing 120, in particular using screws.

## Claims

1. A busbar assembly (1) of an electrical equipment (100), the busbar assembly (1) comprising:
- a set of electrical plate conductors (2);
- at least one magnetic core device (3), the set of electrical plate conductors (2) being configured to pass through the at least one magnetic core device (3);
- connecting elements (4) configured to electrically connect each of the set of electrical plate conductors (2) to an electronic board (110) of the electrical equipment (100);
- a mechanical holder (5) having a first lateral face (521) comprising slots (51), each slot (51) being respectively traversed by one electrical plate conductor of the set of electrical plate conductors (2), the mechanical holder (5) being configured to mechanically support the set of electrical plate conductors (2), the mechanical holder (5) being independent from the at least one magnetic core device (3).

2. The busbar assembly (1) as claimed in the preceding claim, wherein the connecting elements (4) comprises vertical pins (41), each of the set of electrical plate conductors (2) having a receiving end (21) protruding from the corresponding electrical plate conductor, the receiving ends (21) being shifted one from another in a longitudinal direction of the set of electrical plate conductors (2) such that each receiving end (21) is configured to receive a corresponding vertical pin (41).

3. The busbar assembly (1) as claimed in any of the preceding claims, each of the set of electrical plate conductors (2) having two faces being opposite one to another, wherein the mechanical holder (5) comprises buffer elements (53) abutting the two faces of each of the set of electrical plate conductors (2), the buffer elements (53) being configured to allow a positioning of the set of electrical plate conductors (2) in a substantially perpendicular direction with respect to the two faces of each of the set of electrical plate conductors (2).

4. The busbar assembly (1) as claimed in any of the preceding claims combined with the claim 2, wherein the mechanical holder (5) comprises openings (54) on a second lateral face (522) opposite to the first lateral face (521), the openings (54) facing each of the receiving ends (21) of the set of electrical plate conductors (2) such that each receiving end goes through and beyond the corresponding opening, the vertical pins (41) being located on an opposite side of the mechanical holder (5) than the set of electrical plate conductors (2).

5. The busbar assembly (1) as claimed in any of the preceding claims combined with the claim 2, wherein the mechanical holder (5) comprises guiding elements (55) for positioning the vertical pins (41).

6. The busbar assembly (1) as claimed in any of the preceding claims, wherein the mechanical holder (5) comprises at least one of a fixation system (56) configured to attach the mechanical holder (5) to a housing (120) of the electrical equipment (100), or a positioning device (56') configured to position the mechanical holder (5) with respect to the housing (120).

7. The busbar assembly (1) as claimed in any of the preceding claims, wherein each of the set of electrical plate conductors (2) comprises a stop system (22) configured to abut a face (31) of one of the at least one magnetic core device (3).

8. The busbar assembly (1) as claimed in any of the preceding claims, wherein the at least one magnetic core device (3) comprises a fixation system (32) configured to attach the at least one magnetic core device (3) to a housing (120) of the electrical equipment (100).

9. The busbar assembly (1) as claimed in any of the preceding claims, wherein the at least one magnetic core device (3) comprises two magnetic core devices being respectively located on both sides of the mechanical holder (5).

10. The busbar assembly (1) as claimed in the preceding claim, wherein the mechanical holder (5) comprises a fixing claw (57) configured to attach together the mechanical holder (5) and one of the two magnetic core devices.

11. An electrical equipment (100) comprising the busbar assembly (1) according to any of the preceding claims, an electronic board (110), and a housing (120), the housing (120) being configured to accommodate the busbar assembly (1) and the electronic board (110), the electronic board (110) comprising spring connectors (111) configured to receive the connecting elements (4) of the busbar assembly (1).

12. The electrical equipment (100) as claimed in the preceding claim, comprising other electronic components (130) such as a DC-link capacitor and a power section, the electrical equipment (100) being an inverter configured to convert a direct current (DC) voltage coming from a high-voltage power supply battery into an alternating current (AC) voltage.

13. An assembling process of the busbar assembly (1) according to any of the claims 1 to 10 combined with the claim 2, the process comprising:
- sliding one of the at least one magnetic core device (3) along the set of electrical plate conductors (2);
- mounting the mechanical holder (5) laterally on the set of electrical plate conductors (2);
- if appropriate, sliding another one of the at least one magnetic core device (3) along the set of electrical plate conductors (2);
- inserting and attaching the vertical pins (41) on the receiving ends (21) of the set of electrical plate conductors (2).

14. An assembling process of the electrical equipment (100) comprising the busbar assembly (1) according to any of the claims 1 to 10 combined with the claim 2, the electronic board (110), and the housing (120), the electronic board (110) comprising spring connectors (111) configured to receive the connecting elements (4), the process comprising:
- assembling the busbar assembly (1) as claimed in the preceding claim;
- disposing the electronic board (110) into the housing (120) and attaching the electronic board (110) to the housing (120);
- inserting the busbar assembly (1) into the housing (120) above the electronic board (110), such that the connecting elements (4) of the busbar assembly (1) are inserted into the spring connectors (111) of the electronic board (110);
- mechanically attaching the mechanical holder (5) and the at least one magnetic core device (3) to the housing (120).
